Europäisches Patentamt

European Patent Office

Office européen des brevets

(11) Veröffentlichungsnummer: **0 453 645 A2**

## (12) EUROPÄISCHE PATENTANMELDUNG

(21) Anmeldenummer: 90123743.8

(22) Anmeldetag: 10.12.90

(51) Int. Cl.⁵: **G01R 33/02**

(30) Priorität: 24.04.90 DE 4013016

(43) Veröffentlichungstag der Anmeldung:
30.10.91 Patentblatt 91/44

(84) Benannte Vertragsstaaten:
AT BE CH DE DK ES FR GB GR IT LI LU NL SE

(71) Anmelder: SIEMENS AKTIENGESELLSCHAFT
Wittelsbacherplatz 2
W-8000 München 2(DE)

(72) Erfinder: Schewe, Herbert, Dr.
Haydnstrasse 58
W-8522 Herzogenaurach(DE)

(54) Magnetfeldsensor einer Schalteinrichtung mit Teilen unterschiedlicher Koerzitivfeldstärke.

(57) Der Magnetfeldsensor (2) einer Schalteinrichtung enthält ein von einer Spulenwicklung (4) umschlossenes Verbundelement (3) aus zwei sich in einer Achsrichtung (A) erstreckenden, ferromagnetischen Elementteilen mit uniaxialer magnetischer Anisotropie bezüglich der Achsrichtung und mit unterschiedlichen magnetischen Koerzitivfeldstärken. Mittels eines externen magnetischen Schaltfeldes ist nur in dem Elementteil mit der kleineren Koerzitivfeldstärke eine spontane Ummagnetisierung hervorzurufen. Erfindungsgemäß sind die Spulenwicklung (4) und die streifenförmigen Elementteile des Verbundelementes (3) als Dünnfilmstrukturen auf einem Substrat aus nicht-magnetischem Material ausgebildet.

FIG 1

EP 0 453 645 A2

Die Erfindung betrifft einen Magnetfeldsensor einer Schalteinrichtung, der ein von einer Spulenwicklung umschlossenes Verbundelement aus zwei sich in einer Achsrichtung erstreckenden ferromagnetischen Elementteilen enthält, die jeweils eine uniaxiale magnetische Anisotropie mit in der Achsrichtung liegender magnetischer Vorzugsrichtung aufweisen und derart aus Materialien mit in dieser Vorzugsrichtung unterschiedlichen magnetischen Koerzitivfeldstärken bestehen, daß mittels eines externen magnetischen Schaltfeldes nur in dem Elementteil mit der kleineren Koerzitivfeldstärke eine spontane Ummagnetisierung hervorzurufen ist. Ein derartiger Magnetfeldsensor geht aus der Veröffentlichung "Siemens Forsch.-u.Entwickl.Ber.", Bd. 15 (1986) Nr. 3, Seiten 135 bis 144 hervor.

In dieser Veröffentlichung ist über einen spontanen Schalteffekt in ferromagnetischen Drähten berichtet, der auf einer schnellen Ausbreitung großer Barkhausen-Sprünge basiert. Entsprechende Drähte sind z.B. die sogenannten "Wiegand-Drähte", die aus einer besonderen ferromagnetischen Legierung bestehen und tordiert sind. Insbesondere können auch spezielle Impulsdrähte derartige Schalteffekte ermöglichen. Ein solcher Impulsdraht stellt ein Verbundelement dar, das sich aus einem drahtförmigen Kern mit einem diesen umschließenden Mantel zusammensetzt. Dabei besteht der Kern aus einem verhältnismäßig weichmagnetischen Material (mit einer Koerzitivfeldstärke $H_{c1}$ zwischen etwa 0,2 und 20 A/cm). Um in diesem Kern durch ein äußeres Magnetfeld (Schaltfeld) eine schnelle, sprungartige Flußänderung und damit eine Umkehr der Magnetisierungsrichtung hervorzurufen, muß er außerdem eine ausgeprägte uniaxiale magnetische Anisotropie mit in seiner Längsrichtung (Achsrichtung) liegender magnetischer Vorzugsrichtung aufweisen. Damit ferner bei einer verhältnismäßig geringen Länge des Kernes die Ausbildung von unerwünschten Abschlußdomänen verhindert wird, ist für den Mantel ein vergleichsweise magnetisch härteres Material (mit einer Koerzitivfeldstärke $H_{c2}$ von mindestens 30 A/cm) gewählt, um so den Kern permanent aufmagnetisieren zu können.

Mit einem entsprechenden Impulsdraht als einem Teil eines Magnetfeldsensors läßt sich dann eine Schalteinrichtung aufbauen. Hierzu befindet sich der Draht in einer ihn umschließenden Spulenwicklung als weiterem Teil des Magnetfeldsensors. Wird nun in dem Kern des Impulsdrahtes mittels eines externen magnetischen Schaltfeldes eine spontane Ummagnetisierung beim Überschreiten einer bestimmten Feldstärkeschwelle hervorgerufen (vgl. hierzu z.B. auch das Buch von E.Kneller: "Ferromagnetismus", Springer-Verlag 1962, insbesondere Seiten 401 bis 408), so wird in der Spulenwicklung ein Spannungsimpuls induziert. Dieser Spannungsimpuls kann mittels einer der Spulenwicklung nachgeordneten Elektronik einen Schaltvorgang auslösen. Derartige Impulsdrähte mit Durchmessern von etwa 50 bis 300 μm können somit ohne weitere Hilfsenergie als Schwellwertschalter für eine Vielzahl von Sensoraufgaben wie z.B. für Drehzahlregler, lineare Weggeber oder lineare Stromwertgrenzgeber, zur analogen Magnetfeldmessung oder als magnetfeldempfindliche Tasten verwendet werden.

Es hat sich jedoch gezeigt, daß die bekannten Impulsdrähte und die sie umgebenden Spulenwicklungen nur mit verhältnismäßig großem Aufwand herstellbar sind und außerdem sich in den Drähten die magnetischen Eigenschaften, insbesondere die geforderten Anisotropieverhältnisse, mit hinreichender Exaktheit nur schwer reproduzierbar einstellen lassen. Dies hat zur Folge, daß die von Magnetfeldsensoren mit gleichem Aufbau erzeugten Impulse vielfach recht unterschiedlich sind.

Aufgabe der vorliegenden Erfindung ist es deshalb, den Magnetfeldsensor mit den eingangs genannten Merkmalen dahingehend auszugestalten, daß die genannten Probleme vermindert sind.

Diese Aufgabe wird erfindungsgemäß dadurch gelöst, daß die Spulenwicklung und die Streifenform aufweisenden ferromagnetischen Elementteile als Dünnfilm-Strukturen auf einem Substrat aus nicht-magnetischem Material ausgebildet sind.

Die mit dieser Ausgestaltung des Magnetfeldsensors einschließlich seiner Spulenwicklung verbundenen Vorteile sind insbesondere darin zu sehen, daß die Dünnfilm-Technik hohen Anforderungen an die Genauigkeit einer Strukturierung und an die Reproduzierbarkeit der magnetischen Eigenschaften genügen kann und eine verhältnismäßig preiswerte Serienfertigung ermöglicht. Insbesondere lassen sich Sensoren mit großer lateraler Auflösung und definierten Impulsverhältnissen aufbauen, so daß mit ihnen ganze Arrays (Reihenanordnungen) aus gleichwertigen Elementen zu erstellen sind.

Vorteilhafte Weiterbildungen des erfindungsgemäßen Magnetfeldsensors gehen aus den Unteransprüchen hervor.

Zur weiteren Erläuterung der Erfindung wird nachfolgend auf die schematische Zeichnung Bezug genommen. Dabei ist in Figur 1 ein erfindungsgemäßer Magnetfeldsensor dargestellt. Figur 2 zeigt den prinzipiellen Aufbau des schichtförmigen Verbundelementes dieses Sensors. Aus den Figuren 3 bis 10 gehen verschiedene Ausbildungsmöglichkeiten von schichtförmigen Verbundelementen hervor. In den Figuren sind sich entsprechende Teile mit denselben Bezugszeichen versehen.

Mit einem Magnetfeldsensor nach der Erfindung ist mittels eines externen Magnetfeldes (Schaltfeldes) ein Schaltvorgang auszulösen. Da die hierfür dem Sensor nachzuordnenden Teile entsprechender Schalteinrichtungen allgemein bekannt sind, wurde in den Figuren auf deren zeichnerische Darstellung verzichtet.

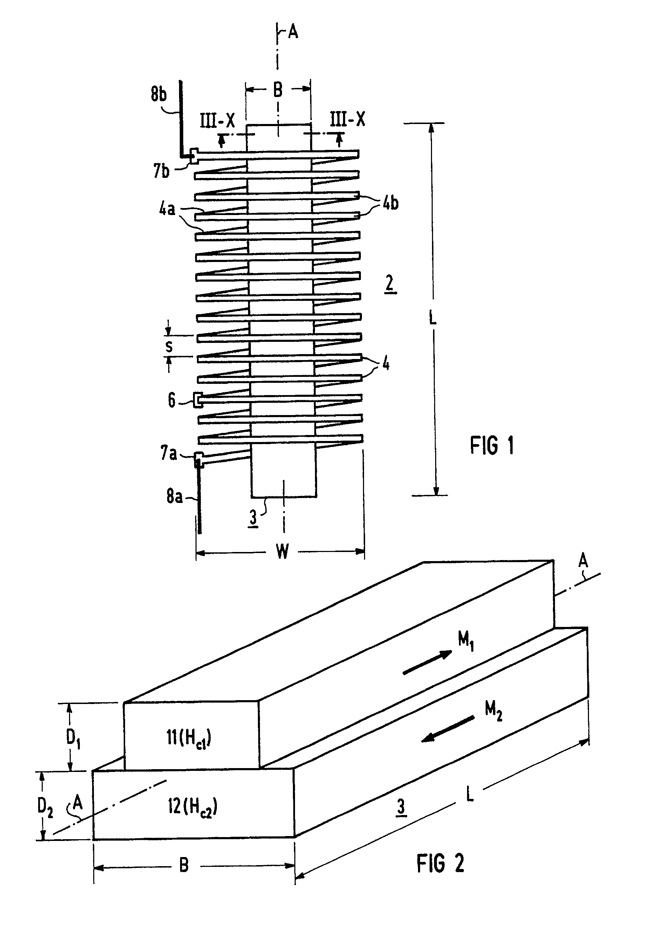

Der in Figur 1 in Aufsicht gezeigte und allgemein mit 2 bezeichnete Magnetfeldsensor nach der Erfindung setzt sich im wesentlichen aus einem schichtförmigen Verbundelement 3 und einer dieses Element umschließenden Spulenwicklung 4 zusammen. Beide Teile 3 und 4 sollen erfindungsgemäß in Dünnfilm-Technik erstellt sein. Das schichtförmige Verbundelement 3 hat in Richtung einer Achse A eine Länge L, die im allgemeinen über 1 mm und beispielsweise unter 2 cm liegt. Die quer zur Achse A zu messende Breite B des Verbundelementes kann einige Mikrometer bis 1 mm betragen. Die Spulenweite W quer zur Achse A liegt im allgemeinen im Bereich des 1,5- bis 3-Fachen der Breite B. Es läßt sich so auf einer vorgegebenen Fläche vorteilhaft eine entsprechend große Zahl von Magnetfeldsensoren zu einem Array anordnen. Die Länge L des Verbundelementes 3, die Leiterbreite b der einzelnen Windungen der Spulenwicklung 4 sowie die Windungssteigung s legen die Anzahl der Windungen der Wicklung fest. Im allgemeinen liegen die Leiterbreite b in der Größenordnung von 1 $\mu$m und die Windungssteigung s unter 10 $\mu$m. So können z.B. bei einer Windungssteigung s von 10 $\mu$m, einer Leiterbreite b von 1 $\mu$m und einer Länge L von 10 mm etwa 1000 Windungen der Wicklung 4 realisiert werden.

Zur Herstellung eines entsprechenden Magnetfeldsensors 2 in Dünnfilm-Technik werden zunächst auf einem Substrat die beispielsweise schräg zu der Achse A verlaufenden, untereinander parallelen unteren Leiterteile 4a der Wicklung 4 aus einem geeigneten Leitermaterial wie z.B. Al, Cu, Ag oder Au abgeschieden. Darauf wird gegenüber diesen Leiterteilen isoliert eine das Verbundelement 3 bildende Schichtenfolge aus verschiedenen ferromagnetischen Materialien aufgebracht und anschließend isoliert. Über diesen Aufbau aus den unteren Leiterteilen 4a und dem Verbundelement 3 hinweg werden dann die sich etwa senkrecht zur Achse A erstreckenden oberen Leiterteile 4b ausgebildet, die dabei mit den entsprechenden unteren Leiterteilen 4a im Randbereich der Spulenwicklung kontaktiert werden. Um dieses Kontaktieren zu erleichtern, ist es vorteilhaft, wenn die entsprechenden Kontaktbereiche der unteren Leiterteile 4a als verhältnismäßig großflächige Kontaktzonen, sogenannte "Kontaktpads" ausgebildet werden. In der Figur ist von diesen Kontaktbereichen zur Vereinfachung der Darstellung nur ein einziger näher ausgeführt und mit 6 bezeichnet. Die Enden der Spulenwicklung 4 werden ebenfalls zweckmäßig als solche großflächige Kontaktbereiche 7a und 7b gestaltet, an denen eine nachgeordnete Elektronik über Anschlußleiter 8a bzw. 8b anzuschließen ist.

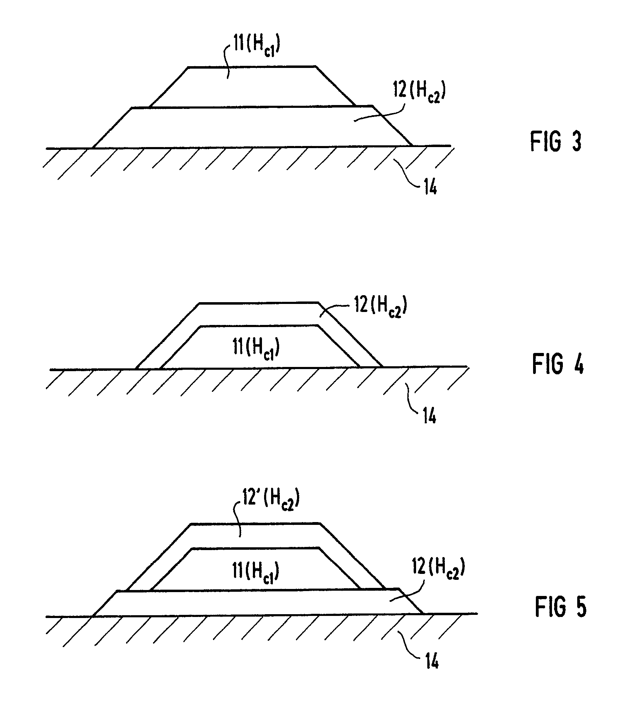

In Figur 2 ist der Aufbau des schichtförmigen Verbundelementes 3 eines erfindungsgemäßen Magnetfeldsensors in Schrägansicht schematisch ausgeführt. Das Verbundelement wird dabei durch ein Schichtsystem aus mindestens zwei übereinander angeordneten, streifenförmigen Elementteilen 11 und 12 gebildet. Diese beiden, nachfolgend als Magnetschichten 11 und 12 bezeichneten Elementteile sollen nämlich aus unterschiedlichen ferromagnetischen Materialien bestehen, die jeweils eine ausgeprägte uniaxiale magnetische Anisotropie mit in Richtung der Achse A liegender magnetischer Vorzugsrichtung und verschiedene Koerzitivfeldstärken $H_{c1}$ bzw. $H_{c2}$ (jeweils in dieser Vorzugsrichtung betrachtet) aufweisen. Hierbei sollte die Koerzitivfeldstärke $H_{c1}$ der Magnetschicht 11 wesentlich kleiner, vorzugsweise mindestens 5 mal kleiner als die Koerzitivfeldstärke $H_{c2}$ der Magnetschicht 12 sein. Im allgemeinen sind für die Magnetschicht 11 weichmagnetische Materialien mit einer Koerzitivfeldstärke $H_{c1}$ von unter 10 A/cm, vorzugsweise unter 1 A/cm geeignet. Beispiele für solche Materialien sind eine CoVFe-Legierung mit 49 Gew.-% Co und 2 Gew.-% V oder eine NiFe-Legierung mit etwa 80 Gew.-% Ni. Demgegenüber sind für die Magnetschicht 12 magnetisch härtere Materialien, insbesondere mit einer Koerzitivfeldstärke $H_{c2}$ von über 50 A/cm, vorzugsweise über 100 A/cm zu wählen. Entsprechende Materialien sind beispielsweise CoPt-, CoNi-, CoFe- oder NiCoFe-Legierungen.

Diese Magnetschichten 11 und 12 werden nach bekannten Verfahren der Dünnfilm-Technik wie z.B. durch Aufdampfen, Sputtern oder galvanische Abscheidung mit Schichtdicken $D_1$ bzw. $D_2$ von jeweils zwischen beispielsweise 1 und 10 $\mu$m hergestellt. Die gewünschte uni axiale Anisotropie kann vorteilhaft in bekannter Weise durch Formanisotropie und/oder Diffusionsanisotropie und/oder Spannungsanisotropie eingestellt werden. Sieht man beispielsweise ein Sputterverfahren vor, so können vorteilhaft die großen mechanischen Spannungen ausgenutzt werden, die bei einer Erwärmung während des Sputterns und einer sich anschließenden Abkühlung aufgrund unterschiedlicher Wärmeausdehnung der Magnetschichten und eines darunterliegenden Substrates entstehen. Außerdem können Spannungen in einer Magnetschicht auch durch die Sputterparameter direkt beeinflußt werden. Darüber hinaus ergibt in einer Schicht eine Zugspannung aufgrund einer positiven Sättigungsmagnetostriktion eines Materials bzw. eine Druckspannung aufgrund einer negativen Magnetostriktion eine Spannungsanisotropie in Richtung der Achse A. Es können deshalb vorteilhaft Materialien gewählt werden, deren Sättigungsmagnetostriktion $\lambda_s$ ungleich null ist, wobei insbesondere gilt: $|\lambda_s| > 10^{-6}$.

Wie ferner in Figur 2 angedeutet ist, liegt die Magnetisierung $M_2$ der hochkoerzitiven Magnetschicht 12 in Richtung der Achse A. Diese Schicht erzeugt dann ein magnetisches Streufeld, das im Bereich der weichmagnetischen Magnetschicht 11 parallel zu deren in der Figur angenommenen Magnetisierung $M_1$ liegt. Die Richtung der jeweiligen Magnetisierung ist dabei in der Figur durch eine gepfeilte Linie veranschaulicht. Zum Ummagnetisieren der Magnetschicht 11 wird nun in bekannter Weise (vgl. die eingangs genannte Veröffentlichung) ein magnetisches Gegenfeld (externes Schaltfeld) parallel zu der Magnetisierung $M_2$ angelegt, so daß beim Erreichen einer bestimmten Schwellwertfeldstärke durch die Magnetschicht 11 eine Ummagnetisierungsfront läuft, die in der sie umgebenden Spulenwicklung eine entsprechende Spannung induziert und die Magnetisierung $M_1$ umkehrt. Anschließend wird die Magnetschicht 11 in bekannter Weise durch ein Rücksetzfeld in den in Figur 2 gezeigten Ausgangszustand wieder zurückversetzt.

In den Figuren 3 bis 10 sind verschiedene Möglichkeiten dargestellt, wie mit Hilfe bekannter Mikrostrukturtechniken die Magnetschichten 10 und 11 des Verbundelementes 3 eines erfindungsgemäßen Magnetfeldsensors auf einer Unterlage angeordnet sein können. Jeder der gezeigten Querschnitte ist dabei außerhalb des Bereichs der Spulenwicklung des Magnetfeldsensors in die Nähe einer der Stirnseiten des jeweiligen Verbundelementes gelegt. Somit erscheint in den Figuren als jeweilige Unterlage des Verbundelementes ein Substrat 14 oder 14'. Dieses Substrat besteht aus einem nicht-magnetischen Material wie z.B. aus Si oder aus einem Kunststoff. Auch Körper aus einem nicht-magnetischen Metall mit einer isolierenden Abdeckung sind als Substrat geeignet.

Gemäß Figur 3 befindet sich auf dem Substrat 14 die hochkoerzitive Schicht 12, die ihrerseits die weichmagnetische Schicht 11 trägt.

Nach Figur 4 wird auf dem Substrat 14 zunächst die weichmagnetische Schicht 11 abgeschieden. Anschließend wird diese Magnetschicht vollständig mit der hochkoerzitiven Schicht 12 abgedeckt.

Die Ausführungsform nach Figur 5 kann dadurch erhalten werden, daß man die weichmagnetische Schicht 11 des Aufbaus gemäß Figur 3 noch zusätzlich mit einer magnetischen Verstärkungsschicht 12' aus dem hochkoerzitiven Material der Schicht 12 überzieht.

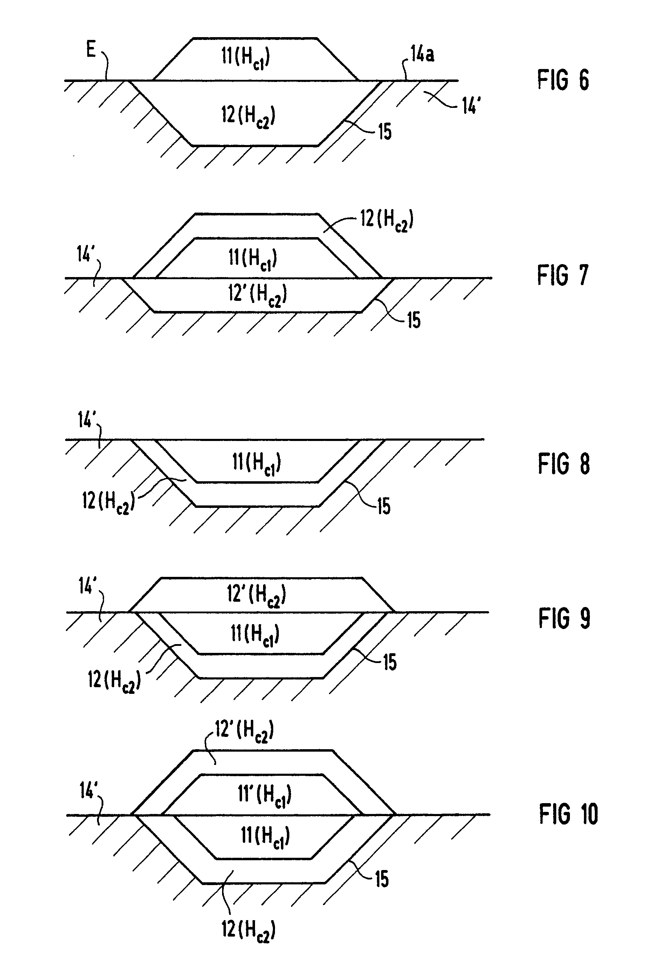

Bei den Ausführungsformen nach den Figuren 3 bis 5 wurde davon ausgegangen, daß die jeweiligen Verbundelemente auf einem ebenen Substrat 14 abgeschieden werden. Ebensogut ist es jedoch auch möglich, mindestens eine der Magnetschichten eines Verbundelementes in einem Substrat 14' versenkt anzuordnen. Ein hierfür geeignetes Verfahren ist in der nicht vorveröffentlichten DE-Patentanmeldung P 38 42 246.8 mit dem Titel "Verfahren zur exakten Ausfüllung einer wannenartigen Vertiefung" beschrieben. Entsprechende Verbundelemente mit in einer Versenkung 15 des Substrates 14' eingelassenen Teilen gehen aus den Figuren 6 bis 10 hervor.

Gemäß Figur 6 ist die hochkoerzitive Magnetschicht 12 vollständig in dem Substrat 14' so versenkt angeordnet, daß sie mit dem nicht-versenkten Teil der Substratoberfläche 14a eine gemeinsame Ebene E bildet. Auf dieser Ebene ist im Bereich der Magnetschicht 12 die weichmagnetische Schicht 11 abgeschieden.

Die Ausführungsform eines Verbundelementes gemäß Figur 7 zeichnet sich dadurch aus, daß in der Versenkung 15 des Substrates 14' eine magnetische Verstärkungsschicht 12' aus dem hochkoerzitiven Material eingelassen ist. Auf dieser Verstärkungsschicht befindet sich ein Aufbau gemäß Figur 4 aus weichmagnetischer Schicht 11 und hochkoerzitiver Schicht 12.

Nach Figur 8 ist in der Versenkung 15 des Substrates 14' der Aufbau gemäß Figur 4 eingelassen, wobei dessen hochkoerzitive Schicht 12 zwischen dem Substrat und der weichmagnetischen Schicht 11 liegt.

Deckt man diesen Aufbau gemäß Figur 8 noch zusätzlich mit einer Verstärkungsschicht 12' aus dem hochkoerzitiven Material ab, so wird die in Figur 9 gezeigte Ausführungsform erhalten.

Statt der Verstärkungsschicht 12' gemäß Figur 9 kann man auch einen Aufbau nach Figur 4 vorsehen und gewinnt so die aus Figur 10 ersichtliche Ausführungsform eines Verbundelementes. Diese Ausführungsform kann als in Mikrostrukturtechnik nachgebildete Version eines Wiegand-Drahtes angesehen werden.

**Patentansprüche**

1. Magnetfeldsensor einer Schalteinrichtung, der ein von einer Spulenwicklung umschlossenes Verbundelement aus zwei sich in einer Achsrichtung erstreckenden ferromagnetischen Elementteilen enthält, die jeweils eine uniaxiale magnetische Anisotropie mit in der Achsrichtung liegender magnetischer Vorzugsrichtung aufweisen und derart aus Materialien mit in dieser Vorzugsrichtung unterschiedlichen magnetischen Koerzitivfeldstärken bestehen, daß mittels eines externen magnetischen Schaltfeldes nur in dem Elementteil mit der kleineren Koerzitivfeldstärke eine spontane Ummagnetisierung hervorzurufen ist, **dadurch gekennzeichnet,** daß die Spulenwicklung (4) und die Streifenform aufweisenden ferromagnetischen Elementteile (11, 11', 12, 12') als Dünnfilm-Strukturen auf einem Substrat (14, 14') aus nicht-magnetischem Material ausgebildet sind.

2. Magnetfeldsensor nach Anspruch 1, **dadurch gekennzeichnet,** daß eine weichmagnetische Magnetschicht (11) des ersten Elementteils eine Koerzitivfeldstärke ($H_{c1}$) aufweist, die mindestens 5 mal kleiner ist als die Koerzitivfeldstärke ($H_{c2}$) einer hochkoerzitiven Magnetschicht (12) des zweiten Elementteils.

3. Magnetfeldsensor nach Anspruch 2, **dadurch gekennzeichnet,** daß die weichmagnetische Magnetschicht (11) aus einem Material mit einer Koerzitivfeldstärke ($H_{c1}$) unter 10 A/cm, vorzugsweise unter 1 A/cm besteht.

4. Magnetfeldsensor nach Anspruch 2 oder Anspruch 3, **dadurch gekennzeichnet,** daß die hochkoerzitive Magnetschicht (12) aus einem Material mit einer Koerzitivfeldstärke ($H_{c2}$) über 50 A/cm, vorzugsweise über 100 A/cm besteht.

5. Magnetfeldsensor nach einem der Ansprüche 2 bis 4, **dadurch gekennzeichnet,** daß mindestens einer der Magnetschichten (11, 12) eine magnetische Verstärkungsschicht (11' bzw. 12') aus dem entsprechenden magnetischen Material zugeordnet ist.

6. Magnetfeldsensor nach einem der Ansprüche 2 bis 5, **dadurch gekennzeichnet,** daß in den Magnetschichten (11, 11', 12, 12') die uniaxiale magnetische Anisotropie durch Formanisotropie und/oder durch Diffusionsanisotropie und/oder durch Spannungsanisotropie eingestellt ist.

7. Magnetfeldsensor nach einem der Ansprüche 1 bis 6, **dadurch gekennzeichnet,** daß die Materialien des Verbundelementes (3) eine von 0 verschiedene Sättigungsmagnetostriktion $\lambda_s$ aufweisen, wobei $|\lambda_s| > 10^{-6}$ gilt.

8. Magnetfeldsensor nach einem der Ansprüche 1 bis 7, **dadurch gekennzeichnet,** daß das Verbundelement (3) zumindest teilweise in einer Versenkung (15) des Substrates (14') angeordnet ist.

EP 0 453 645 A2

FIG 1

FIG 2

6

11(H$_{c1}$)

12(H$_{c2}$)

14

FIG 3

12(H$_{c2}$)

11(H$_{c1}$)

14

FIG 4

12'(H$_{c2}$)

11(H$_{c1}$)

12(H$_{c2}$)

14

FIG 5

FIG 6

FIG 7

FIG 8

FIG 9

FIG 10